# EUROPEAN PATENT APPLICATION

(11) **EP 2 234 467 A1**
(43) Date of publication of application: **29.09.2010**
(21) Application number: 09155893.2
(22) Date of filing: 23.03.2009
(51) Int. Cl.: H05K 5/06, G08B 21/02

(54) **Portable transmitter/transponder device**

(71) Applicant: STT Condigi AB, 212 37 Malmö (SE)
(72) Inventor: Arlemark, Malkus, 216 13 Limhamn (SE)
(74) Representative: Karlsson, Leif Gunnar Börje

(57) **Abstract**

A portable transmitter/transponder device comprises:
- a base part (102),
- a circuit board (106),
- a cover (112),
wherein the cover is made of a resilient material and comprises a circumferential bead/groove (114) which fits matingly with circumferential groove/bead (116) of the base part, so as to prevent dust and water to enter the interior of the personal transmitter device.

## Description

### Field of the Invention

The present invention relates to a portable transmitter/transponder device, and in particular to a portable transmitter/transponder device, which uses wireless techniques to establish communication between the device and another unit.

### Technical Background

A portable transmitter/transponder device of the above kind is commonly used among elderly or physically disabled, as a personal alarm device. The device is usually in the shape and size of a conventional wristwatch, and may be provided with a wristband or a neckband in order to be arranged around the wrist or neck of the user. In this way the personal alarm device may be readily available for the user in case of emergency. For ease of use the personal alarm device generally only comprises a single button to be pressed, and by pressing the single button a distress signal is communicated to the caregiver.

The personal alarm device is usually provided with wireless means of communication in order to communicate with a base unit via e.g. a radio frequency signal. The base unit may in turn communicate with the caregiver by means of a regular or mobile telephone connection, or via the Internet etc. Even if the personal alarm device only communicates a distress signal, the base unit may add more details to the signal before passing it forward to the caregiver, such as particulars regarding the location, physical state etc of the person in distress, if such sensors are available in the personal alarm device/base unit. As the technical progress develops more means of communications emerges and the present invention to be disclosed should not be limited in this aspect.

It is beneficial if the portable transmitter/transponder device is dustproof as well as waterproof, since this increases the durability of it, and enables the user to wear it at all times. Personal alarm devices fulfilling these requirements exist yet they commonly suffer from the drawback of being difficult to open for the person using them, or even for a caregiver. In this respect they may be compared with a waterproof watch. A situation when it is important to reach the inner parts of the personal alarm device is when the power source, usually a small battery, is to be exchanged. If opened by a non-skilled person, using a set of tools, this may lead to scratching or other undesired manipulations of the device. Also, these personal alarm devices may have a quite bulky design, which makes them less desirable to wear, and less comfortable when worn.

The present invention provides a convenient solution to the above and other problems, relating to portable transmitter/transponder devices.

### Summary

The present invention achieves the above objective by the provision of a personal transmitter/transponder device comprising, a base part, a circuit board, and a cover, and is **characterized in that** the cover is made of a resilient material and comprises a circumferential bead/groove which fits matingly with circumferential groove/bead of the base part, so as to prevent dust and water to enter the interior of the personal transmitter device.

The inventive device provides the possibility to be opened and serviced without using tools by the serviceperson. The usage of tools to open previous devices often damages the sealing surfaces or the interlocking parts of the unit compromising the sealing of the unit. This invention also, with its few parts and preferably smooth shape, makes it easier to clean and keep hygienic. In one or more embodiments silicone may be used as material for the cover, which has been proven to be an outstanding material in medical applications providing an efficient protective shield with high resistance to chemicals that the user may come in contact with during use. Silicone also does not yield its strength over time and keeps the radial force constant to the housing over time providing a reliable sealing.

According to one embodiment the device comprises a power source and optionally also an actuator for actuation of a signal to be sent.

According to one or more embodiments a portion of the cover may comprise a translucent area, such that light from light-emitting means arranged on the circuit board may pass the translucent area. This makes it possible for the personal transmitter device to communicate with a user by means of light signals. A suitable method of achieving translucent areas is by means of laser-etching of a coating of the cover.

In one embodiment, which may be combined with any embodiment described above or below, an additional carrying member is snap-lockable to the base part and adapted to prevent the cover from disengaging with said base part in a radial direction. Once the cover is engaged with the base part it may be removed by the application of a force in a radial direction, which breaks the bead/groove engagement. The provision of the carrying member accomplishes at least three beneficial effects:
a) the bead/groove engagement cannot be broken,
b) the rim edge of the cover is protected from wear and tear,
c) attachment means may be arranged on the carrying member.

For the engagement between the carrying member and the base part it is preferable that the carrying member comprises a circumferential bead/groove which fits matingly with a circumferential groove/bead of the base part.

For ease of manufacture and assembly/disassembly, it is preferable that portions of inter-engagement of the base part, the cover and, when available, the carrying member, have a rotational symmetry (i.e. that they are essentially circular).

In order to increase durability and sealing properties it is preferable that the cover is made in one piece from a single material. This may also be true for the base part and the carrying member.

According to one or more embodiments the cover is provided with a lacquer or paint, which is selectively and locally removed by means of laser etching. The cover may then be coated. This is a convenient method to achieve said translucent areas.

The light-emitting means preferably comprises one or more LEDs, but may comprise other light-emitting means.

The inventive device comprises means for performing the required actions, such as communication with a base unit, signalling according to a preset protocol etc.

### Brief Description of the Drawings

Fig. 1 is an exploded sectional view of an inventive portable transmitter/transponder device according to a first embodiment of the present invention.
Fig. 2 is a cross section of the device similar to the one of Fig. 1, in an assembled state.

### Detailed Description

One embodiment of the present invention is described in the form of a personal alarm device.

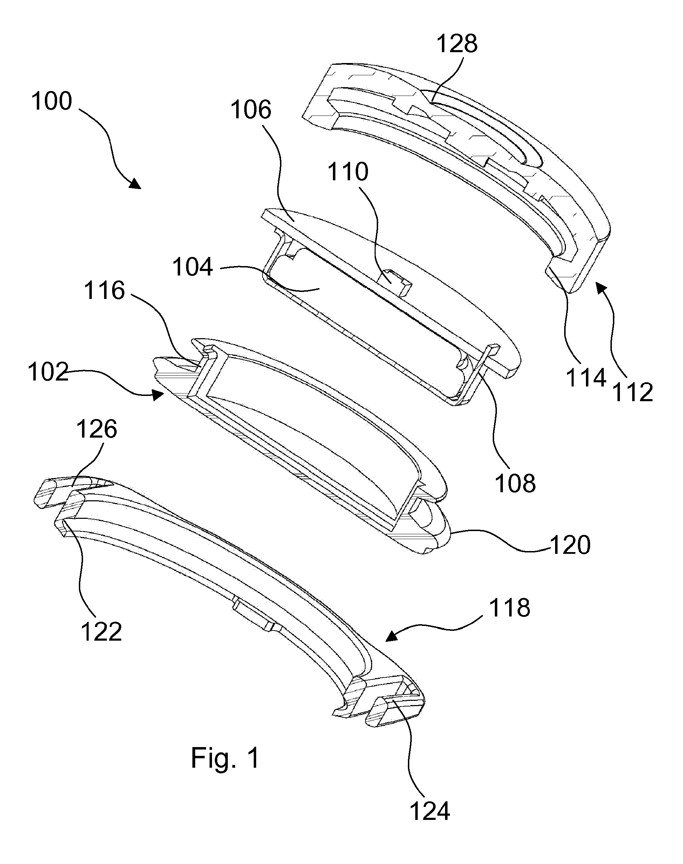

Fig. 1 is an exploded view of a personal alarm device 100 according to a first embodiment of the present invention, showing the most relevant constructional parts. A base part 102 made of plastic constitutes housing for the battery 104 and a support for a circuit board 106. The battery 104 is electrically connected to the circuit board 106 via a battery contact plate 108. The base part 102 may comprise a recess for accommodation of the battery contact plate 108, which saves space and serves the additional purpose of preventing the circuit board 106 from rotating when engaged in the base part 102. The circuit board 106 carries the components needed for processing and communication (not shown) and on its upper side an actuator 110 is arranged in the form of a contact breaker. Pressing the contact breaker 110 will set of the alarm. A cover 112 made of silicone is designed to be connected to the base part 102 in order to form a waterproof and dustproof housing for the electronics contained therein. For this purpose the cover 112 has a circumferential bead 114, which matingly fits into a groove 116 of the base part 102. The cover 112 preferable fits into the groove 116 in a slightly stretched condition, so as to generate a racial biasing force, improving the sealing properties. The assembled alarm device 100 may in one embodiment be arranged in a carrying member 118. A snap-lock mechanism may secure the first in the latter, in that a circumferential bead 120 of the base part 102 fits into a circumferential groove 122 of the carrying member 118. The design of the carrying member 118 may be varied with the intended use of the device. The carrying member 118 shown in the present drawing is designed for the device 100 to be carried in a wristband fastened in the ears 124, 126, similar to a wristwatch. Another design may be used if the device 100 is intended to be carried like a necklace, etc, and the present invention should not be limited in this respect.

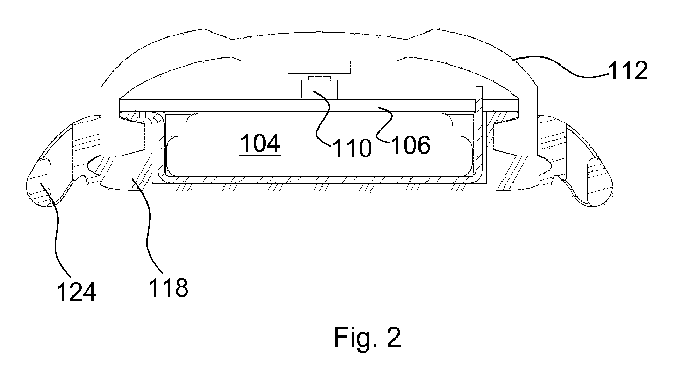

Another constructional feature of the carrying member 118 is that it may effectively sandwich the cover 112 between an inner surface of the carrying member and the outer surface of the base part 102. In this way the bead 114 of the cover 112 will be secured in the groove 116 of the base part 102. This feature is best seen in the view of an assembled personal security device, as shown in Fig. 2.

The cover 112 comprises a resilient material such that the actuator 110 may be operated by applying pressure to the cover 112 in the direction of the actuator 110. The design of the upper part of the cover 112 may be such that it is immediately apparent where a user should apply pressure for actuation. In one embodiment an annular area 128 is made more translucent than the rest of the device, such that the light from a LED (not shown) arranged inside the device may pass through the cover in this area. By varying the intensity or a pulsation frequency of the light the light may be used for multiple purposes, such as display of technical information including signalling operation, battery failure, connection with a base station etc and general information, such as when it is time for the user to administer medicaments, perform a self-diagnostic check etc. All signalling may be performed according to a preset protocol stored on a central processing unit on the printed circuit board. The suggested method for obtaining the translucent area is by applying a lacquer or paint and subsequent coating to the entire part. The type of lacquer/paint/coating used may vary with the type of material selected for the component, yet selecting a suitable product is a straightforward task for the skilled person. Thereafter selected areas may be laser etched and coated in order to be translucent. Laser etching is a precision operation, and the shape of the translucent areas may be realized with great detail. Various translucent areas may be used for various purposes, and by using more than one LED, more than one colour of the LED, etc, various translucent areas may be activated in a simple and straightforward manner. The LED or LEDs are generally arranged on upper side of the printed circuit board, in one or several locations thereon, in the volume defined between the cover 112 and the printed circuit board 106. Further, there are other methods of obtaining a translucent area, such as masking selected areas of the component prior to surface treatment.

It should be noted if a translucent material, such as silicone, is used signaling may be performed through the material as such, yet the above described method will improve the clarity of the signaling.

From the drawings it is obvious that the portions of inter-engagement between the base part 112, the cover 102 and the carrying member 118 are essentially circular, as are the general shape of the individual parts as a whole. The portions of inter-engagement may be pre-treated with e.g. an adhesive or a lubricant in order to improve the sealing properties, by providing chemical bonding or by improving distribution of forces.

When exchanging batteries of an inventive device according to the illustrated embodiments, the base part 102 is simply pressed out of engagement with the carrying member 118, whereafter the cover 112 is pulled or pushed out of engagement with the base part 102. In one preferred embodiment the circuit board 106 is held in place in the base part 102 by the cover 112, and after removing the cover 112 the circuit board 106 may be turned upside-down for access to the battery 104.

The skilled person being introduced to the present invention realizes that it may be modified in several aspects relative to the embodiments described herein without departing from the scope of protection as defined by the appended claims. Examples of modifications relates to the materials selected for the constructional parts. The cover 112, may comprise silicone or other polymeric/plastic/rubber material having a suitable resilience/elasticity for the above described engagement with the base part 102. To increase durability the cover 112 may preferably be constructed in one piece of a single material. This may preferably also be the case for the carrying member and the base part. The cover 112 may also be painted or coated, fully or partionally, leaving transparent areas for optical signaling. The base part 102 as well as the carrying member may be constructed from plastic or machined/casted metal being corrosion resistant by itself or treated in order to be. Further, cooperating grooves and beads may be arranged in a reversed manner, such that the cover includes a circumferential groove fitting matingly with a circumferential bead of the base part, instead of the other way around, yet the order presented in the disclosed embodiment is currently believed to be the most space efficient and durable.

To this end it should be noted that even though the present device has been described in terms of a personal alarm device, the inventive concept may be used for other portable transmitter/transponder devices, that may be used for access control, communication with other base units (such as an alarm unit, access unit etc). In the described embodiment the device is active, in that an actuator is pressed for operation, yet the device may also be passive such that a communication is established between the device and a base unit when certain condition prevails (such as a certain distance between the device and the base unit). In such a case the device may comprise a passive RFID circuit, or similar component, and should as such enabling communication between a portable device and a base unit, and the communication may be in the form of electromagnetic waves, such as radio waves or IR-radiation, or audio waves, such as ultrasound.

## Claims

1. A portable transmitter/transponder device comprising
- a base part (102),
- a circuit board (106), and
- a cover (112),
**characterised in that** the cover is made of a resilient material and comprises a circumferential bead/groove which fits matingly with circumferential groove/bead of the base part, so as to prevent dust and water to enter the interior of the personal transmitter device.

2. A portable transmitter/transponder device according to claim 1, further comprising a power source, and/or an actuator.

3. The portable transmitter/transponder device of any preceding claim, wherein part of the cover comprises a translucent area, such that light from light-emitting means arranged in connection with the circuit board may pass the translucent area.

4. The portable transmitter/transponder device of claim 3, wherein the translucent area is accomplished by means of laser-etching of a coating of the cover.

5. The portable transmitter/transponder device of any preceding claim, wherein an additional carrying member is snap-lockable to the base part and adapted to prevent the cover from disengaging with said base part in a radial direction.

6. The portable transmitter/transponder device of claim 5, wherein the carrying member enables the device to be carried on the wrist or around the neck of a user.

7. The portable transmitter/transponder device of claim 5 or 6, wherein the carrying member comprises a circumferential bead/groove which fits matingly with a circumferential groove/bead of the base part.

8. The portable transmitter/transponder device of any preceding claim, where portions of inter-engagement of the base part, the cover and, when available, the carrying member, have a rotational symmetry.

9. The portable transmitter/transponder device of any preceding claim, wherein the cover is made in one piece from a single material.

10. The portable transmitter/transponder device of any preceding claim, wherein the cover is provided with a lacquer or paint which is selectively and locally removed by means of laser etching.

11. The portable transmitter/transponder device of any preceding claim, wherein the inner dimensions of the cover, in the area of engagement with the base part, are smaller than the outer dimensions of the base part, such that a radial biasing force is generated.

12. A system comprising: a base unit and a portable transmitter/transponder device according to any preceding claim, wherein the personal transmitter device and the base unit are adapted for mutual communication, and wherein the base unit is destined to transmit a control signal as a response to the communication.
